# EUROPEAN PATENT APPLICATION

(11) **EP 1 458 027 A1**
(43) Date of publication of application: **15.09.2004**
(21) Application number: 02781808.7
(22) Date of filing: 18.11.2002
(51) Int. Cl.: H01L 27/108, H01L 21/8242, H01L 27/10

(54) **SEMICONDUCTOR DEVICE**

(30) Priority: 19.11.2001 JP 2001352487; 21.08.2002 JP 2002240131
(71) Applicant: MATSUSHITA ELECTRIC INDUSTRIAL CO., LTD., Kadoma-shi, Osaka 571-8501 (JP)
(72) Inventor: HIRANO, Hiroshige, Nara-shi, Nara 631-0076 (JP); YAMAOKA, Kunisato, Takatsuki-shi, Osaka 569-1141 (JP)
(74) Representative: Grünecker, Kinkeldey, Stockmair & Schwanhäusser Anwaltssozietät
(86) International application number: PCT/JP2002/012029
(87) International publication number: WO 2003/044862

(57) **Abstract**

A first wiring layer overlying a semiconductor substrate has the arrangement of adjacent wirings in the order of first wirings and first shield wirings. A second wiring layer overlying the semiconductor substrate has the arrangement of adjacent wirings in the order of second shield wirings and second wirings to correspond to the respective first wirings and first shield wirings in the first wiring layer. Thus, the capacitance between adjacent wirings is reduced as well as the noise between adjacent wirings. Further, power consumption is reduced without a decrease in the action speed of a signal.

## Description

### Technical Field

The present invention relates to a wiring structure of a semiconductor device.

### Background Art

As the designs of semiconductor devices become finer, a capacitance between wirings has become a problem on circuit designs. Particularly, a capacitance between adjacent wirings delays the driving time of signal lines.

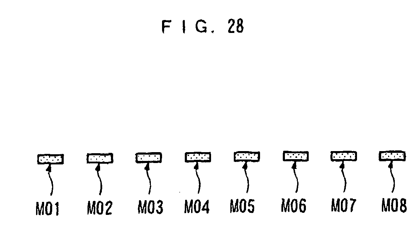

Referring to FIG. 28, an example of a conventional wiring structure will be briefly described. FIG. 28 shows an example of wiring only using a single wiring layer. The wiring layer has a tight arrangement. In this way, as a wiring layer making contact with the source or drain of a device such as a transistor, the lowest wiring layer is generally used, and the minimum wiring is frequently provided according to a pitch of contact.

However, the conventional semiconductor device increases a capacitance between adjacent wirings and increases noise between adjacent wirings, lowering the operating speed of signals.

Further, as a capacitance between wirings becomes larger, power consumption also increases.

Moreover, when the wiring structure is used for a bit line of a memory, it is difficult to read a necessary potential from a memory cell to the bit line.

Additionally, in reverse, in the case of memory such as a ferroelectric memory or the like requiring a suitable wiring capacitance, it is difficult to reduce noise between adjacent wirings and set a suitable wiring capacitance at the same time.

Under the circumstances, an object of the present invention is to provide a semiconductor device which can reduce a capacitance between adj acent wirings, noise between adjacent wirings, and power consumption without lowering the operating speed of a signal.

### Disclosure of Invention

A semiconductor device according to the present invention has the following wiring structure.

Wirings are formed in a plurality of wiring layers and a distance is increased between the wiring layers to reduce noise between the wiring layers. First, a capacitance between wirings between the layers is reduced, and wirings in a first wiring layer and a second wiring layer are arranged on different positions taken from the top, so that a capacitance between wirings can be reducedbetween the first wiring layer and second wiring layer.

Moreover, the following wiring structure is provided: a first wiring, a first shield wiring, and a second wiring are arranged in this order in the first wiring layer, and a third wiring, a second shield wiring, and a fourth wiring are arranged in this order in the second wiring layer.

Besides, the first shield wiring and the second shield wiring are ground voltage lines or power voltage lines. Further, the ground voltage lines and the power voltage lines are alternately arranged, or the first wiring layer is used as a ground voltage line and the second wiring layer is used as a power voltage line.

Moreover, the arrangement has two wiring layer regions and the wirings of the wiring layer regions are connected to each other, so that the wiring structure can offer a preferred balance of a resistance and a capacitance.

Moreover, the shield wiring is larger in width than the signal wiring in the wiring structure.

Besides, the lowest wiring layer is constituted of a single wiring layer as with the conventional art. An upper layer thereon has a wiring structure of a first wiring, a first shield wiring, and a second wiring that are arranged in this order. An upper layer thereon has a wiring structure of a third wiring, a second shield wiring, and a fourth wiring that are arranged in this order.

According to these arrangements of the semiconductor device, it is possible to reduce a capacitance between adj acent wirings, noise between adjacent wirings, andpower consumption without lowering the operating speed of a signal.

### Brief Description of Drawings

FIG. 1 is a top view showing a semiconductor device according to Embodiment 1 of the present invention;
FIG. 2 is a sectional view showingthe semiconductor device according to Embodiment 1 of the present invention;
FIG. 3 is a top view showing a semiconductor device according to Embodiment 2 of the present invention;
FIG. 4 is a sectional view showing the semiconductordevice according to Embodiment 2 of the present invention;
FIG. 5 is a top view showing a semiconductor device according to Embodiment 3 of the present invention;
FIG. 6 is a top view showing a semiconductor device according to Embodiment 4 of the present invention;
FIG. 7 is a top view showing a semiconductor device according to Embodiment 5 of the present invention;
FIG. 8 is.a top view showing a semiconductor device according to Embodiment 6 of the present invention;
FIG. 9 is a top view showing a semiconductor device according to Embodiment 7 of the present invention;
FIG. 10 is a top view showing a semiconductor device according to Embodiment 8 of the present invention;
FIG. 11 is a top view showing a semiconductor device according to Embodiment 9 of the present invention;
FIG. 12 is a sectional view showing the semiconductor device according to Embodiment 9 of the present invention;
FIG. 13 is a top view showing a semiconductor device according to Embodiment 10 of the present invention;
FIG. 14 is a sectional view showing the semiconductor device according to Embodiment 10 of the present invention;
FIG. 15 is a top view showing a semiconductor device according to Embodiment 11 of the present invention;
FIG. 16 is a sectional view showing the semiconductor device according to Embodiment 11 of the present invention;
FIG. 17 is a top view showing a semiconductor device according to Embodiment 12 of the present invention;
FIG. 18 is a sectional view showing the semiconductor device according to Embodiment 12 of the present invention;
FIG. 19 is a sectional view showing the semiconductor device according to Embodiment 12 of the present invention;
FIG. 20 is a top view showing a semiconductor device according to Embodiment 13 of the present invention;
FIG. 21 is a sectional view showing the semiconductor device according to Embodiment 13 of the present invention;
FIG. 22 is a top view showing a semiconductor device according to Embodiment 14 of the present invention;
FIG. 23 is a sectional view showing the semiconductor device according to Embodiment 14 of the present invention;
FIG. 24 is a sectional view showing a semiconductor device according to Embodiment 15 of the present invention;
FIG. 25 is a sectional view showing a semiconductor device according to Embodiment 16 of the present invention;
FIG. 26 is a top view showing a semiconductor device according to Embodiment 17 of the present invention;
FIG. 27 is a sectional view showing the semiconductor device according to Embodiment 17 of the present invention; and
FIG. 28 is a sectional view showing a conventional semiconductor device.

### Best Mode for Carrying Out the Invention

With reference to the accompanying drawings, a semiconductor device according to embodiments of the present invention will be specifically described below.

### (Embodiment 1)

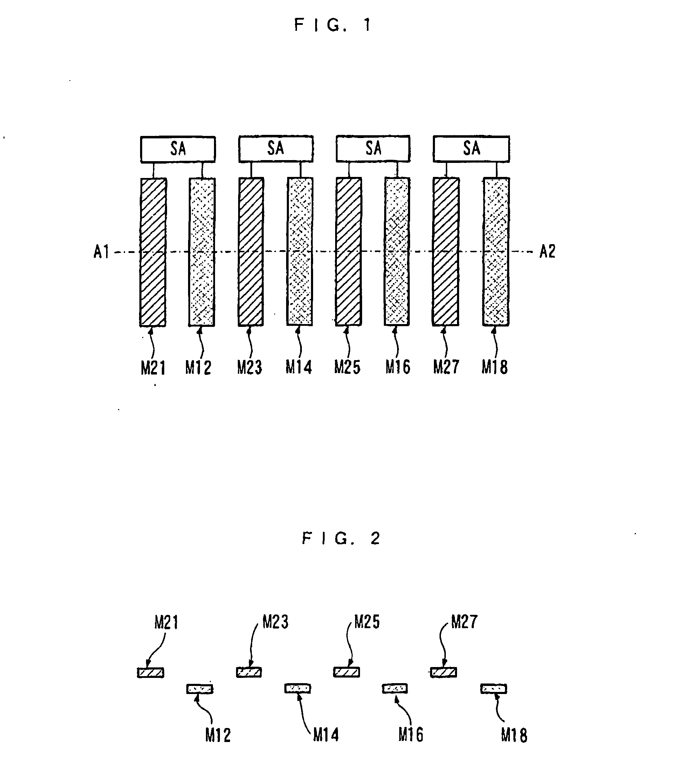

Embodiment 1 of the present invention will be discussed below according to the accompanying drawings. FIG. 1 is a top view of Embodiment 1, and FIG. 2 is a sectional view taken along line A1-A2 of FIG. 1.

First, wirings (e.g., signal lines) M12, M14, M16, and M18 are arranged in this order in a first wiring layer. Then, on the first wiring layer, signal lines M21, M23, M25, and M27 are arranged in this order in a second wiring layer. In this case, the signal lines in the first wiring layer and the second wiring layer are arranged at almost equal intervals. Further, the signal lines M21 and M12, the signal lines M23 and M14, the signal lines M25 and M16, and the signal lines M27 and M18 are connected to amplifiers. In the present embodiment, the signal lines M12, M14, M16, and M18 and the signal lines M21, M23, M25, and M27 are arranged on different positions taken from the top. As compared with the case where the signal lines are arranged on the same positions taken from the top, noise can be reduced between the signal lines.

Embodiment 1 has the following effect: the signal lines are arranged using the two wiring layers and shield wirings are placed between the signal lines, so that it is possible to reduce a capacitance between adjacent wirings, noise between adjacent wirings, and power consumption without reducing the operating speed of a signal. Particularly, since the signal lines of the first wiring layer and the second wiring layer are arranged on different positions taken from the top, a great effect can be achieved.

### (Embodiment 2)

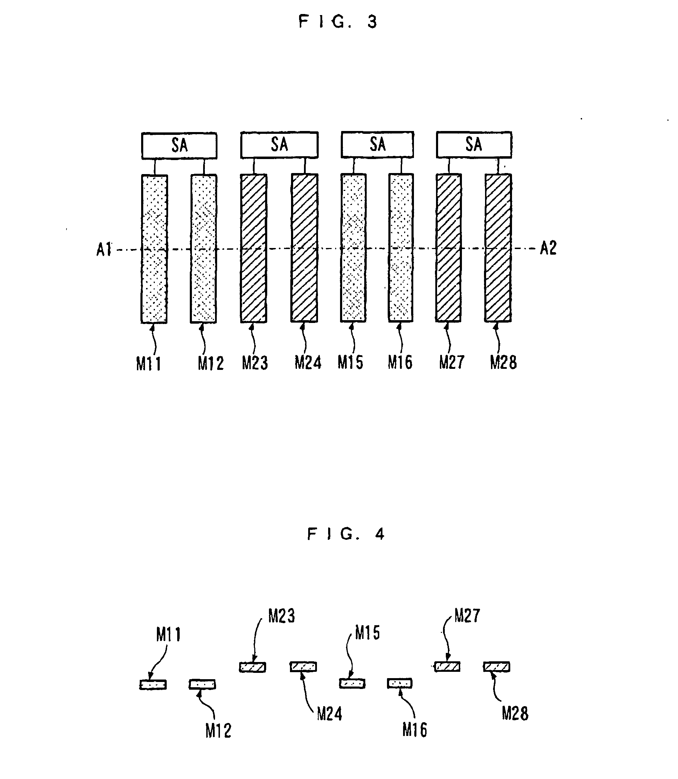

Embodiment 2 of the present invention will be discussed below according to the accompanying drawings. FIG. 3 is a top view of Embodiment 2, and FIG. 4 is a sectional view taken along line A1-A2 of FIG. 3.

Unlike Embodiment 1, a first wiring layer and a second wiring layer have adjacent signal lines in pairs in the present embodiment. Wirings are not arranged at equal intervals in each of the wiring layers. Further, the signals of the adjacent wirings are connected to amplifiers.

Embodiment 2 has the following effect: signal lines are arranged using two wiring layers as with Embodiment 1, so that it is possible to reduce a capacitance between adjacent wirings, noise between adjacent wirings, and power consumption without reducing the operating speed of a signal. Particularly since the signal lines of the first wiring layer the second wiring layer are arranged on different positions taken from the top, a great effect can be achieved.

Additionally, since the wirings connected to the same amplifier are arranged in the same layer, it is possible to reduce the influence of variations or the like during the manufacturing of the wirings.

### (Embodiment 3)

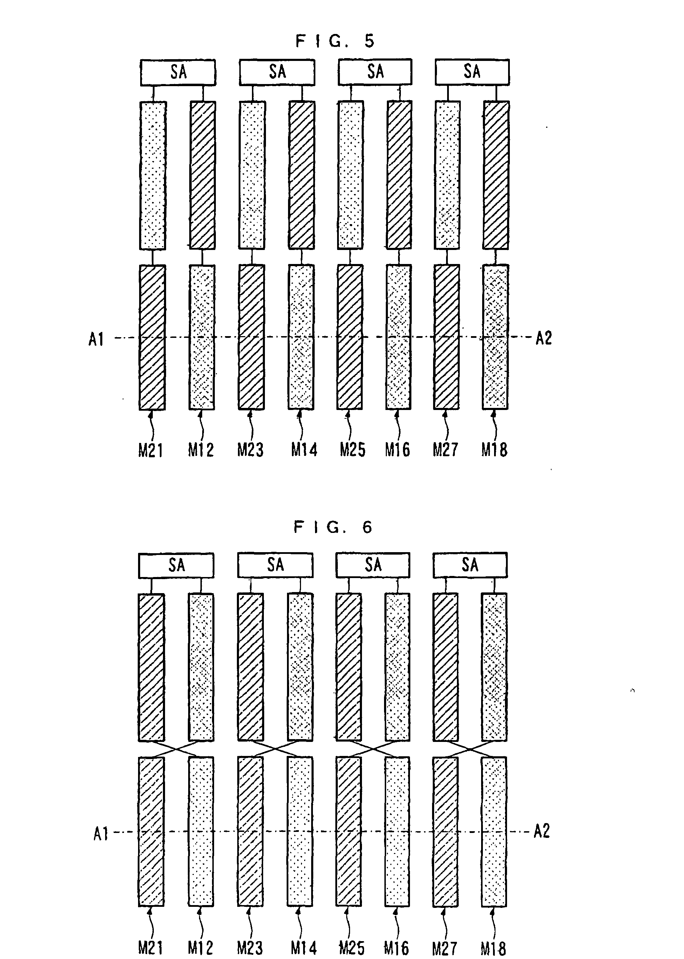

Embodiment 3 of the present invention will be discussed below according to the accompanying drawings. FIG. 5 is a top view of Embodiment 3.

Unlike Embodiment 1, electrically connected wirings are transferred to and from a first wiring layer and a second wiring layer at some midpoint in the present embodiment. Since this structure has both regions of the first wiring layer and the second wiring layer, the same arrangement is provided over the wirings.

With this arrangement, it is possible to reduce the influence of variations or the like during the manufacturing of the wiring.

Further, the electrically connected wirings on signals are arranged almost like a straight line taken from the top. The connecting part of the wirings in the first wiring layer and the second wiring layer do not intersect the other wirings, achieving a simple layout. The connection configuration of amplifiers is the same as Embodiment 1.

### (Embodiment 4)

Embodiment 4 of the present invention will be discussed below according to the accompanying drawings. FIG. 6 is a top view of Embodiment 4.

Unlike Embodiment 1, electrically connected wirings are transferred to and from a first wiring layer and a second wiring layer at some midpoint in the present embodiment. Since this structure has both regions of the first wiring layer and the second wiring layer, so that the same arrangement is provided over the wirings.

With this arrangement, it is possible to reduce the influence of variations or the like during the manufacturing of the wirings.

Further, taken from the top, the electrically connected wirings on signals are not arranged almost like a straight line taken from the top but the wirings in the same wiring layer are arranged almost like a straight line. For example, when another wiring layer is provided on the second wiring in the same direction, almost equal noise is set for a pair of wirings connected to the same amplifier, thereby reducing the influence of noise. The configuration of connecting the amplifiers is the same as that of Embodiment 1.

### (Embodiment 5)

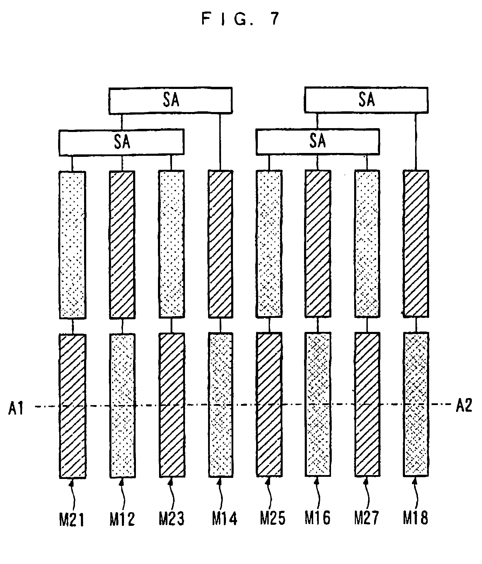

Embodiment 5 of the present invention will be discussed below according to the accompanying drawings. FIG. 7 is a top view of Embodiment 5.

In the present embodiment, the wiring constitution is the same as Embodiment 3 but the connecting positions of amplifiers are different from those of Embodiment 3. Two wirings connected to the same amplifier are arranged on the same position in the wiring direction in the same wiring layer.

With this arrangement, for example, when a signal wiring crosses two wirings connected to the same amplifier, noise from the signal can be cancelled.

### (Embodiment 6)

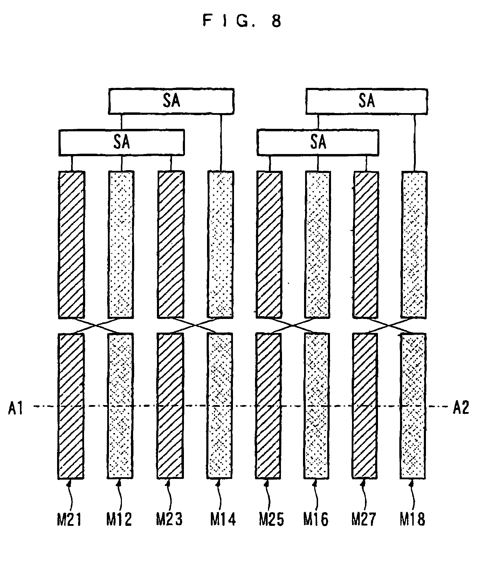

Embodiment 6 of the present invention will be discussed below according to the accompanying drawings. FIG. 8 is a top view of Embodiment 6.

Embodiment 4 and Embodiment 5 are combined in the present embodiment and the same effects of the embodiments 4 and 5 are obtained.

### (Embodiment 7)

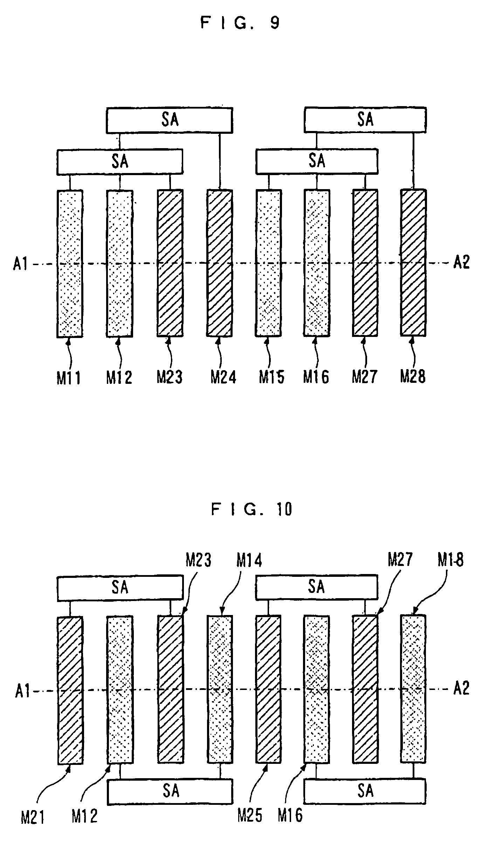

Embodiment 7 of the present invention will be discussed below according to the accompanying drawings. FIG. 9 is a top view of Embodiment 7.

In the present embodiment, the arrangement of connected amplifiers is changed from the wiring constitution of Embodiment 2. In this arrangement, for example, when a method of operating one of two amplifiers is used, a signal wiring connected to the amplifier not being operated has the effect of a shield wiring. Hence, the same effect can be obtained as the case where a shield wiring is arranged on an adjacent wiring in the same layer.

### (Embodiment 8)

Embodiment 8 of the present invention will be discussed below according to the accompanying drawings. FIG. 10 is a top view of Embodiment 8.

Unlike the wiring constitution of Embodiment 1, in the present embodiment, the arrangement of connected amplifiers is changed and the amplifiers are placed on both ends of a wiring. In this arrangement, like Embodiment 5, two wirings connected to the same amplifier are arranged on the same position in the wiring direction in the same wiring layer. When a signal wiring crosses two wirings connected to the same amplifier, noise from the signal can be cancelled.

### (Embodiment 9)

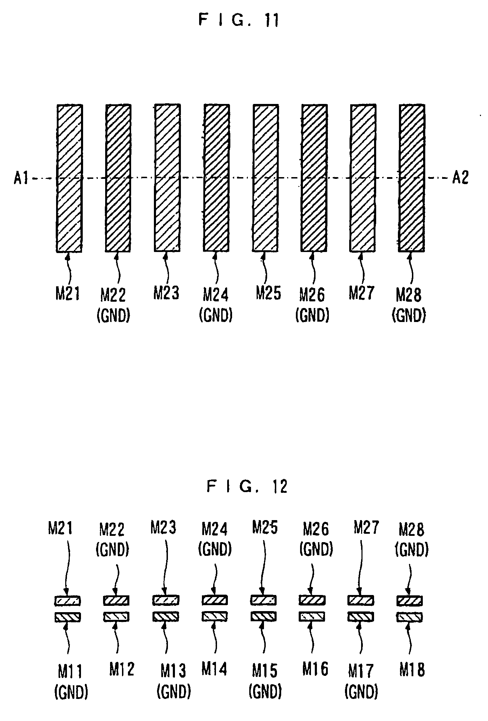

Embodiment 9 of the present invention will be discussed below according to the accompanying drawings. FIG. 11 is a top view of Embodiment 9, and FIG. 12 is a sectional view taken along line A1-A2 of FIG. 11. Only the wiring of a second wiring layer on the upper surface side is illustrated in the top view.

First, wirings M11 to M18 are arranged in this order in a first wiring layer. The wirings M12, M14, M16, and M18 are used as signal lines. The wirings M11, M13, M15, and M17 arranged between the signal lines M12, M14, M16, and M18 are provided as shield wirings for reducing noise on the signal lines.

Subsequently, on the first wiring layer, wirings M21 to M28 are arranged in this order in the second wiring layer. Here, the wirings M21, M23, M25, and M27 are used as signal lines. The wirings M22, M24, M26, and M28 arranged between the signal lines M21, M23, M25, and M27 are provided as shield wirings for reducing the noise of the signal lines.

In the present embodiment, the signal lines M12, M14, M16, and M18 and the signal lines M21, M23, M25, and M27 are arranged on different positions taken from the top, and the shield wirings are arranged between the signal lines. The shielding effect between the signal lines can be increased as compared with the case where the signal lines are arranged on the same positions taken from the top, thereby further reducing the noise of the signal lines. Further, although the shield wirings are connected to a ground voltage line (GND potential) in this arrangement, the shield wirings may be connected to a power voltage line.

Embodiment 9 has the following effect: the signal lines are arranged using the two wiring layers and the shield wirings are arranged between the signal lines, so that it is possible to reduce a capacitance between adjacent wirings, noise between adjacent wirings, and power consumption without reducing the operating speed of a signal. Particularly since the signal lines of the first wiring layer and the second wiring layer are arranged on different positions taken from the top, achieving a great effect of shielding noise.

Further, the ground voltage line serving as a shield wiring may be used as a ground voltage line wired from a power supply or the like.

### (Embodiment 10)

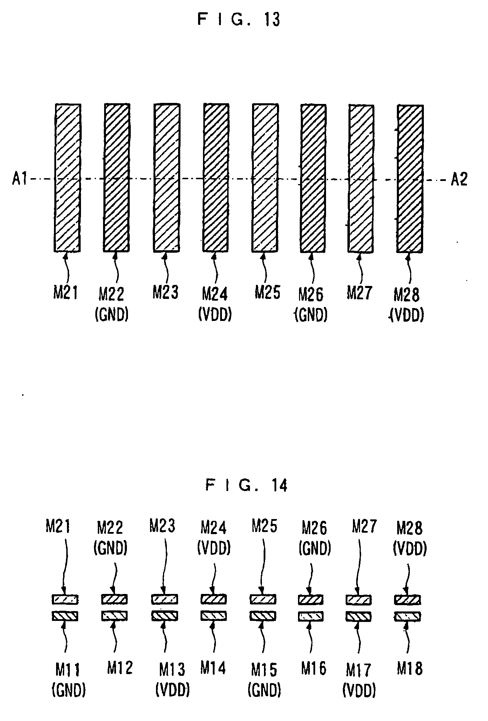

Embodiment 10 of the present invention will be discussed below according to the accompanying drawings. FIG. 13 is a top view of Embodiment 10, and FIG. 14 is a sectional view taken along line A1-A2 of FIG. 13. Only the wiring of a second wiring layer on the upper surface side is illustrated in the top view.

The arrangement of signal lines is the same as Embodiment 9. Embodiment 10 is characterized in that shield wirings are connected to both of a ground voltage line and a power voltage line.

Shield wirings M11, M13, M15, and M17 in a first wiring layer are connected alternately to the ground voltage line and the power voltage line, and shield wirings M22, M24, M26, and M28 in a second wiring layer are connected alternately to the ground voltage line and the power voltage line. Although the shield wirings are connected alternately to the ground voltage line and the power voltage line, the order is not always limited and the most suitable setting can be used in accordance with the layout.

Embodiment 10 has the same effect as Embodiment 9, and the shield wirings on both of the ground voltage line and the power voltage line are used. Thus, the signals can be used as power supply signals of the circuit.

### (Embodiment 11)

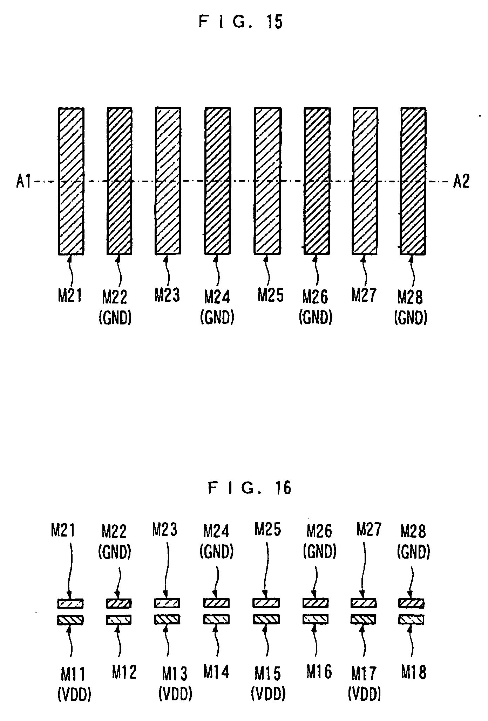

Embodiment 11 of the present invention will be discussed below according to the accompanying drawings. FIG. 15 is a top view of Embodiment 11, and FIG. 16 is a sectional view taken along line A1-A2 of FIG. 15. Only the wiring of a second wiring layer on the top surface side is illustrated in the top view.

The arrangement of signal lines is the same as Embodiment 9 and Embodiment 10. Embodiment 11 is characterized in that shield wirings in a first wiring layer are connected to a power voltage line and shield wirings in the second wiring layer are connected to a ground voltage line.

To be specific, shield wirings M11, M13, M15, and M17 in a first wiring layer are connected to the power voltage line (VDD potential) and shield wirings M22, M24, M26, and M28 in a second wiring layer are connected to the ground voltage line (GND potential).

In this case, the shield wirings in the first wiring layer are used as the power voltage line and the shield wirings in the second wiring layer are used as the ground voltage line. The reversed arrangement can be used as necessary. The shield wirings in the same wiring layer are used as the same voltage line, achieving a simple layout.

Embodiment 11 has the same effect as Embodiment 9 and Embodiment 10. Regarding the ground voltage line and the power voltage line, the shield wirings in the same wiring layer are used as the same voltage line, achieving a simple layout.

### (Embodiment 12)

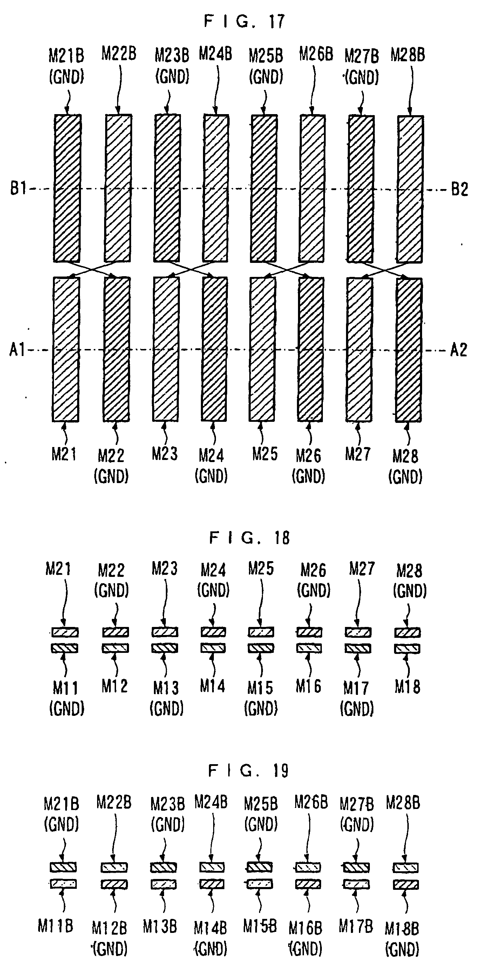

Embodiment 12 of the present invention will be discussed below according to the accompanying drawings. FIG. 17 is a top view of Embodiment 12, FIG. 18 is a sectional view taken along line A1-A2 of FIG. 17, and FIG. 19 is a sectional view taken along line B1-B2 of FIG. 17. Only the wiring of a second wiring layer on the top surface side is illustrated in the top view.

In Embodiment 12, a wiring region is broadly divided into two regions and the two regions of the wiring constitutions in Embodiment 9 are provided. Further, the wiring of a first wiring layer and the wiring of the second wiring layer in the two regions are replaced with each other and are connected to each other. With this arrangement, each of the wirings is provided both in the first wiring layer and the second wiring layer, so that a balance of a capacitance and a resistance can be offered on the wirings and a stable operation can be performed when the wirings are used as bit lines or the like of a memory.

The detailed arrangement will be discussed below. First, in a first wiring region (cross section along line A1-A2 of FIG. 18), wirings M11 to M18 are arranged in this order in the first wiring layer. In this arrangement, wirings M12, M14, M16, and M18 are used as signal lines. The wirings M11, M13, M15, and M17 arranged between the signal lines M12, M14, M16, and M18 are used as shield wirings for reducing the noise of the signal lines.

Then, on the first wiring layer, wirings M21 to M28 are arranged in this order in the second wiring layer. In this arrangement, the wirings M21, M23, M25, and M27 are used as signal lines. The wirings M22, M24, M26, and M28 arranged between the signal lines M21, M23, M25, and M27 are used as shield wirings for reducing the noise of the signal lines.

Subsequently, a similar wiring constitution is provided in the second wiring region (cross section along line B1-B2 of FIG. 19). For example, the line M12 is connected to a line M22B, the line M14 is connected to a line M24B, the line M16 is connected to a line M26B, the line M18 is connected to M28B, the line M21 is connected to a line M11B, the line M23 is connected to a line M13B, the line M25 is connected to a line M15B, and the line M27 is connected to a line M17B.

In this arrangement, the shield wirings are connected to a ground voltage line (GND potential). Of course, the shield wirings may be connected to a power voltage line, or both of the ground voltage line and the power voltage line may be used. Although the arrangement is constituted of the two wiring regions, more wiring regions may be provided. When the number of wiring regions is increased, it is possible to offer a preferred balance of a capacitance and a resistance on each of the wirings.

Embodiment 12 has the same effect as -Embodiment 9. The wiring region is divided into two or more regions and the wirings of the regions are replaced with each other before being connected, so that a balance of a capacitance and a resistance on each of the wirings is improved and a stable operation can be performed.

### (Embodiment 13)

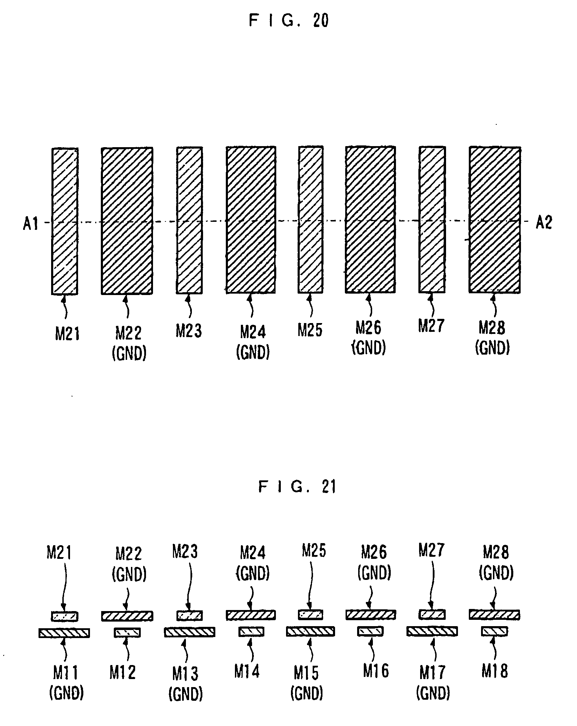

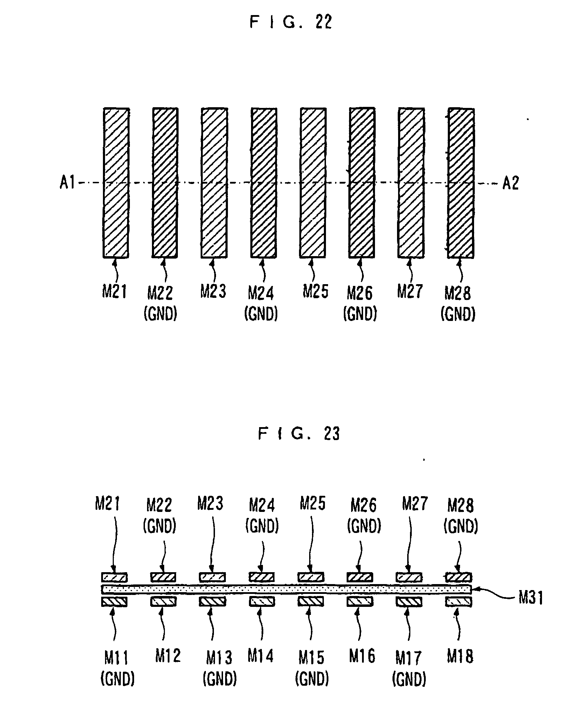

Embodiment 13 of the present invention will be discussed below according to the accompanying drawings. FIG. 20 is a top view of Embodiment 13, and FIG. 21 is a sectional view taken along line A1-A2 of FIG. 20. Only the wiring of a second wiring layer on the top surface side is illustrated in the top view.

The arrangement of signal lines is similar to that of Embodiment 9. Embodiment 13 is characterized in that a shield wiring is larger in width than a signal line.

Shield wirings M11, M13, M15, and M17 in a first wiring layer and shield wirings M22, M24, M26, and M28 in a second wiring layer are larger in width than signal lines M12, M14, M16, M18, M21, M23, M25, and M27.

Embodiment 13 has the same effect as Embodiment 9. With a larger width of the shield wiring, the shielding effect can be higher than that of Embodiment 9.

Taken from the top, the shield wirings in the first wiring layer and the shield wirings in the second wiring layer do not overlap each other in the present embodiment. When the shield wirings overlap each other, the shielding effect can be further increased.

### (Embodiment 14)

Embodiment 14 of the present invention will be discussed below according to the accompanying drawings. FIG. 22 is a top view of Embodiment 14, and FIG. 23 is a sectional view taken along line A1-A2 of FIG. 22. Only the wiring of a second wiring layer on the top surface side is illustrated in the top view.

The arrangement of signal lines in a first wiring layer and the second wiring layer is similar to that of Embodiment 9. A shield layer M31 serving as a third wiring layer is placed between the first wiring layer and the second wiring layer.

Since Embodiment 14 has the shield layer M31 placed as the third wiring layer, the shielding effect can be increased.

### (Embodiment 15)

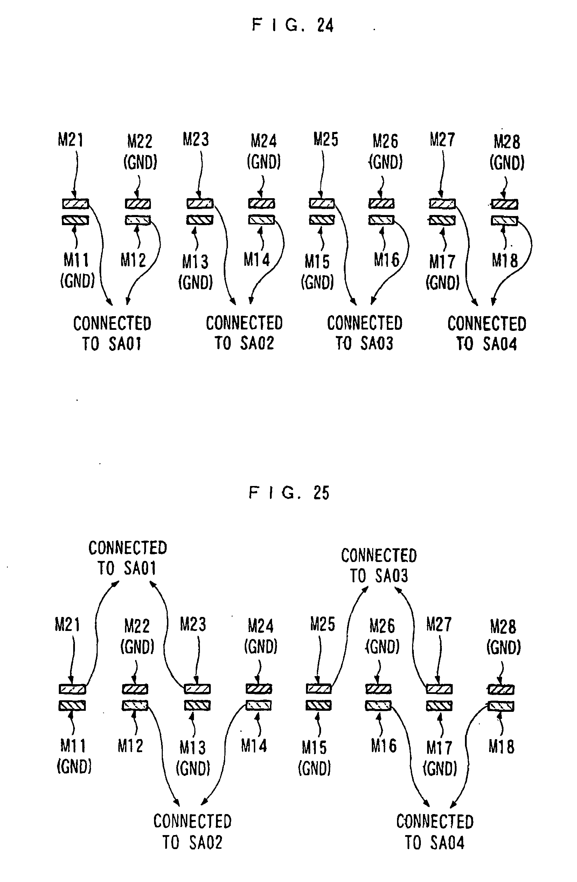

Embodiment 15 of the present invention will be discussed below according to the accompanying drawings. Regarding wirings arranged as signal lines, FIG. 24 is a diagram showing a connecting relationship with sense amplifiers.

Signal lines M12 and M21, signal lines M14 and M23, signal lines M16 and M25, and signal lines M18 and M27 are connected to sense amplifiers SA01, SA02, SA03, and SA04, respectively.

In Embodiment 15, adjacent signal lines of the signal lines in a first wiring layer and a second wiring layer are connected to the sense amplifiers. When this arrangement is used for bit lines of a memory, adjacent memory cells can be used and thus a stable operation can be obtained for the memory.

### (Embodiment 16)

Embodiment 16 of the present invention will be discussed below according to the accompanying drawings. Regarding wirings arranged as signal lines, FIG. 25 shows a connecting relationship with sense amplifiers.

Signal lines M21 and M23, signal lines M12 and M14, signal lines M25 and M27, and signal lines M16 and M18 are connected to sense amplifiers SA01, SA02, SA03, and SA04, respectively.

In Embodiment 16, the signal lines connected to the sense amplifier can be separated away from each other, thereby reducing the influence of noise between adjacent signal lines.

### (Embodiment 17)

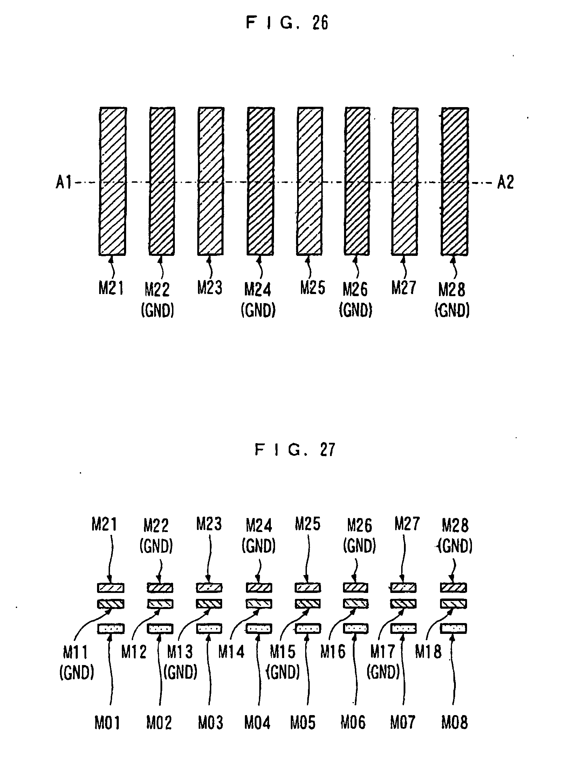

Embodiment 17 of the present invention will be discussed below according to the accompanying drawings. FIG. 26 is a top view of Embodiment 17, and FIG. 27 is a sectional view taken along line A1-A2 of FIG. 26. Only the wiring of a second wiring layer on the top surface side is illustrated in the top view.

Signal lines are arranged by combining the arrangement of Embodiment 9 and a conventional arrangement which is tightly wired as the lowest wiring layer. The wiring of the lowest layer and the signal lines of a first wiring layer and a second wiring layer are electrically connected to each other. This arrangement is used for a memory array using a main bit line and a sub bit line, so that it is possible to achieve a memory array capable of reducing a capacitance between adjacent wirings and noise between adjacent wirings without lowering the operating speed of a signal.

The above explanation described Embodiments 1 to 17. An arrangement using these embodiments in parallel is also applicable, which is included in the present invention.

Further, the operating method described in Embodiment 7 is also applicable to the other embodiments. With the operation method of prohibiting half of a plurality of amplifiers from being operated, signal lines connected to amplifiers are used as shield wirings, thereby reducing noise.

Moreover, Embodiment 17 described that the wirings in the lowest layer are arranged in the conventional structure. This arrangement is also applicable to the other embodiments.

Moreover, although the two different wiring layers were discussed in the above explanation, three ormore wiring layers may be arranged.

## Claims

1. A semiconductor device, in which a first wiring, a second wiring, a third wiring, and a fourth wiring are formed in a first direction in a first wiring layer, a fifth wiring, a sixth wiring, a seventh wiring, and an eighth wiring are formed in the first direction in a second wiring layer provided on an upper layer of the first wiring layer, and the first wiring, the second wiring, the third wiring, the fourth wiring, the fifth wiring, the sixth wiring, the seventh wiring, and the eighth wiring are formed so as to hardly overlap one another taken from a top.

2. The semiconductor device according to claim 1, wherein the first wiring, the second wiring, the third wiring, and the fourth wiring in the first wiring layer are arranged at almost equal intervals.

3. The semiconductor device according to claim 1, wherein regarding the first wiring, the second wiring, the third wiring, and the fourth wiring in the first wiring layer, an interval between the first wiring and the second wiring and an interval between the third wiring and the fourth wiring are different from each other.

4. The semiconductor device according to claim 1, wherein the first wiring, the second wiring, the third wiring, and the fourth wiring are formed in the first direction in the first wiring layer, the fifth wiring, the sixth wiring, the seventh wiring, and the eighth wiring are formed in the first direction in the second wiring layer provided on the upper layer of the first wiring layer, a ninth wiring, a tenth wiring, an eleventh wiring, and a twelfth wiring are formed in the first direction in the second wiring layer and are connected to the first wiring, the second wiring, the third wiring, and the fourth wiring, respectively, and a thirteenth wiring, a fourteenth wiring, a fifteenth wiring, and a sixteenth wiring are formed in the first direction of the first wiring layer and are connected to the fifth wiring, the sixth wiring, the seventh wiring, and the eighth wiring, respectively.

5. The semiconductor device according to claim 1, wherein the first wiring and the fifth wiring, the second wiring and the sixth wiring, the third wiring and the seventh wiring, and the fourth wiring and the eighth wiring are connected to first, second, third, and fourth amplifiers, respectively.

6. The semiconductor device according to claim 1, wherein the first wiring and the second wiring, the third wiring and the fourth wiring, the fifth wiring and the sixth wiring, and the seventh wiring and the eighth wiring are connected to first, second, third, and fourth amplifiers, respectively.

7. The semiconductor device according to claim 1, wherein the first wiring and the fifth wiring, the second wiring and the sixth wiring, the third wiring and the seventh wiring, and the fourth wiring and the eighth wiring are connected to first, second, third, and fourth amplifiers, respectively.

8. The semiconductor device according to claim 1, wherein a first shield wiring, a second shield wiring, a third shield wiring, and a fourth shield wiring are formed between the first wiring, the second wiring, the third wiring, and the fourth wiring in the first wiring layer, and a fifth shield wiring, a sixth shield wiring, a seventh shield wiring, and an eighth shield wiring are formed between the fifth wiring, the sixth wiring, the seventh wiring, and the eighth wiring in the second wiring layer.

9. The semiconductor device according to claim 4, wherein a first shield wiring, a second shield wiring, a third shield wiring, and a fourth shield wiring are formed between the first wiring, the second wiring, the third wiring, and the fourth wiring in the first wiring layer, a fifth shield wiring, a sixth shield wiring, a seventh shield wiring, and an eighth shield wiring are formed between the fifth wiring, the sixth wiring, the seventh wiring, and the eighth wiring in the second wiring layer, a ninth shield wiring, a tenth shield wiring, an eleventh shield wiring, and a twelfth shield wiring are formed between the ninth wiring, the tenth wiring, the eleventh wiring, and the twelfth wiring in the second wiring layer, and a thirteenth shield wiring, a fourteenth shield wiring, a fifteenth shield wiring, and a sixteenth shield wiring are formed between the thirteenth wiring, the fourteenth wiring, the fifteenth wiring, and the sixteenth wiring in the first wiring layer.

10. The semiconductor device according toclaim 8 or 9, wherein the first to eighth shield wirings are used as ground voltage lines and power voltage lines.

11. The semiconductor device according to claim 8 or 9, wherein the shield wirings are larger in width than the wirings.

12. The semiconductor device according to claim 1 or 8, further comprising a third wiring layer between the wirings and shield wirings formed in the first wiring layer and the wirings and shield wirings formed in the second wiring layer, wherein the third wiring layer is a third shield wiring.

13. The semiconductor device according to claim 1 or 8, further comprising a wiring layer formed by the fourth wiring layer under the first wiring layer.
